# FASCICULE DE BREVET EUROPEEN

(11) **EP 0 486 596 B1**
(45) Date de publication et mention de la délivrance du brevet: **05.04.1995**
(21) Numéro de dépôt: 90912874.6
(22) Date de dépôt: 10.08.1990
(51) Int. Cl.: G01N 27/16

(54) **CAPTEUR A FILAMENT EN COUCHE MINCE AUTOPORTE, SON PROCEDE DE FABRICATION ET SES APPLICATIONS DANS LA DETECTION DE GAZ ET EN CHROMATOGRAPHIE GAZEUSE**
SELBSTTRAGENDER DÜNNSCHICHTSENSOR, VERFAHREN ZU SEINER HERSTELLUNG UND ANWENDUNG IN DER GASDETEKTION UND GASCHROMATOGRAPHIE
SELF-SUPPORTING THIN-FILM FILAMENT DETECTOR, PROCESS FOR ITS MANUFACTURE AND ITS APPLICATIONS TO GAS DETECTION AND GAS CHROMATOGRAPHY

(30) Priorité: 11.08.1989 FR 8910837
(43) Date de publication de la demande: 27.05.1992
(73) Titulaire: L'INSTITUT NATIONAL DE L'ENVIRONNEMENT INDUSTRIEL ET DES RISQUES, F-60550 VERNEUIL-EN-HALATTE (FR); COMMISSARIAT A L'ENERGIE ATOMIQUE, 75015 Paris (FR)
(72) Inventeur: ACCORSI, Antoinette 1047, rue Saint-Gervais, F-60700 Pont-Sainte-Maxence (FR); CHARLOT, Daniel, F-38330 Saint-Ismier (FR)
(74) Mandataire: Rinuy, Santarelli
(86) Numéro de dépôt international: FR9000608
(87) Numéro de publication internationale: WO9102242

(56) Documents cités:
- EP-A- 0 313 390
- EP-A- 0 377 792
- DE-A- 3 028 249
- DE-A- 3 743 398
- GB-A- 2 158 586

## Description

La présente invention concerne un capteur du type à filament pour la détermination d'une caractéristique statique ou dynamique d'un milieu gazeux environnant, tel que l'air par exemple, un procédé pour sa fabrication, et des applications de ce capteur, principalement dans la détection de gaz oxydables mais aussi en chromatographie gazeuse (détection de gaz ionisables) ou encore dans la mesure de débits fluides.

Un tel capteur du type à filament peut se définir comme étant un capteur comportant un élément résistif au sein d'un filament destiné à échanger de la chaleur avec l'environnement, ainsi qu'une zone d'interface adaptée à réagir avec ce milieu selon un processus physico-chimique (au sens le plus large du terme : catalyse de combustion, adsorption, ionisation, simple échange thermique) influant, en fonction de la caractéristique du milieu à déterminer (concentration, débit ...), sur une caractéristique électrique de cette zone d'interface (température ou résistance, tension, intensité..). Cette zone d'interface peut aussi bien être la portion externe de l'élément résistif, qu'une couche catalytique chauffée par conduction, une électrode distincte.

Certains de ces capteurs sont ainsi fondés sur une mesure de chaleur échangée (détection de gaz combustible, debitmètre ...) et on peut les qualifier de capteurs calorimétriques; on peut aussi recenser divers capteurs du type à filament ayant en commun de mesurer une concentration, en étant fondés sur des phénomènes divers (mesure de chaleur échangée dans le cas de la détection de gaz combustible ou oxydable par exemple, mesure de quantités d'ions recueillis par une électrode dans la chromatographie gazeuse par exemple ....). Les capteurs du type à filament regroupent donc des capteurs très divers, tant en ce qui concerne le phénomène physico-chimique sur lequel ils sont fondés qu'en ce qui concerne la nature de la grandeur à mesurer.

C'est pourquoi, si la suite de l'exposé se réfère principalement à la détection d'un gaz oxydable dans un milieu gazeux tel que l'air, dans le domaine par exemple de l'explosimétrie, il s'agit d'une application préférée mais non limitative de l'invention.

De manière connue en soi, la détection d'un gaz oxydable dans l'air est assurée par un filament, généralement de platine, chauffé par effet JOULE, c'est à dire par passage d'un courant électrique. Le gaz oxydable contenu dans l'air environnant s'oxyde par catalyse au contact du filament, d'où un échauffement supplémentaire de ce dernier. La variation de température qui en résulte provoque une variation de la résistance du filament, dont la mesure directe ou indirecte permet d'avoir accès à la concentration dudit gaz oxydable dans l'air. Ces détecteurs à base de filament sont faits de manière assez artisanale, comportant une partie de fabrication manuelle. Ils souffrent donc d'un manque de reproductibilité et d'un prix de revient élevé. Leur faible résistance électrique, et leur faible rapport surface/volume, obligent à travailler à haute température (1000°C environ).

D'autres détecteurs de gaz oxydable sont constitués à partir de perles catalytiques; ils sont formés d'un détecteur métallique (par exemple en platine) enrobé d'alumine dopée à l'aide d'un catalyseur, ayant l'apparence d'une petite perle. Le vieillissement de ces détecteurs est moins rapide, car la température de combustion qui leur est associée est plus faible. Cependant, ces perles souffrent d'une dérive importante de la sensibilité, d'une stabilité moins grande et d'un temps de réponse plus long que les filaments.

Un troisième type de détecteur de gaz oxydable a été réalisé à partir d'oxydes métalliques semiconducteurs dopés avec un catalyseur. Ces détecteurs sont formés d'un filament métallique de chauffage, chauffant un manchon isolant, en alumine par exemple, sur lequel est déposée une couche de matériau semiconducteur, dont on mesure les variations de résistances. Ces détecteurs sont sensibles à tout gaz adsorbable à la surface du semiconducteur. Mais ils ont un temps de réponse assez long et une consommation électrique importante ; de plus l'influence de l'humidité n'y est pas compensée.

Une présentation brève et générale des capteurs à filaments ou à perles catalytiques est donnée dans le préambule du document WO-90/12313 (à prendre en considération selon l'article 54(3) CBE en ce qui concerne ses enseignements).

Un autre type de dispositif détecteur est décrit dans le document DE-A-3.743.398 : le dispositif détecteur comporte un substrat semiconducteur dans lequel est ménagée une ouverture ; ce substrat se prolongeant dans cette ouverture par deux bras recouverts d'une couche de passivation ; ces bras portent par leurs extrémités un élément semiconducteur de faible étendue, sensible à la température, en contact avec une couche de matériau catalytique. Il ne s'agit pas d'un détecteur à filament.

Quant au document GB-A-2.158.586, il décrit un dispositif pour la détection de la combustion catalytique du méthane. Une résistance de chauffage en couche mince ou épaisse est déposée sur un substrat muni sur son autre face d'un élément sensible à la température. Une couche catalytique est déposée sur la résistance de chauffage et éventuellement sur le substrat. Il peut y avoir des pertes thermiques par conduction au sein du substrat plan.

Le document EP-A-0.377.792, à prendre en considération selon l'article 54(3)CBE pour AT, CH, DE, FR, GB, IT, NL, décrit un capteur pour la détection de gaz comprenant une plaque de support comportant une fenêtre, une couche isolante couvrant la plaque de support et constituant une membrane libre au-dessus de la fenêtre. Sur cette couche isolante sont disposées des résistances en couche mince, une couche de protection et une couche catalytique recouvrant la zone adaptée à être chauffée par les résistances. Il y a des risques de pertes thermiques par conduction transversalement aux résistances.

L'invention vise à pallier les inconvénients précités en améliorant la reproductibilité et en réduisant les pertes thermiques du filament par conduction, notamment transversalement au filament, tout en abaissant les coûts de fabrication.

De manière très générale, elle propose à cet effet un capteur à filament pour la détermination d'une caractéristique statique ou dynamique d'un milieu environnant, comportant un élément résistif destiné à être chauffé par effet JOULE dans ce milieu, et une zone d'interface adaptée à réagir avec ce milieu selon un processus physico-chimique influant, en fonction de la caractéristique à déterminer, sur une caractéristique électrique de cette zone d'interface, ce capteur comportant une lame de support traversée par au moins un évidement et au moins un filament incluant cet élément résistif, constitué d'une ou plusieurs couche(s) mince(s) et comportant une portion centrale s'étendant librement dans l'évidement et au moins deux portions d'extrémité par lesquelles cette portion centrale est reliée à la lame de support, grâce à quoi ce filament est autoporté.

En d'autres termes l'invention propose un filament réalisé à l'aide des technologies de la microélectronique, construit de telle façon qu'il "s'autosupporte", c'est-à-dire que ses seuls éléments de liaison avec le support sont des couches minces : le filament est ainsi constitué d'une ou plusieurs couches minces "en l'air" ce qui réduit considérablement les pertes thermiques par conduction.

L'invention résulte de la constatation qu'il était possible, grâce à cette technologie des couches minces, de réaliser un filament présentant une résistance mécanique et une tenue aux chocs thermiques suffisantes pour qu'il puisse s'autoporter.

Les demanderesses ont en effet constaté de manière surprenante que, malgré la finesse du filament qui lui confère la résistance électrique voulue, celui-ci est à la fois suffisamment sensible pour permettre la réaction physico-chimique à l'origine de la mesure et suffisamment résistant pour ne pas s'user prématurément en contact avec le milieu environnant.

Selon des dispositions préférées de l'invention :
- le filament est formé d'une couche en matériau métallique catalytique dont la surface extérieure constitue ladite zone d'interface;
- le filament, au moins dans sa portion centrale, est formé d'un empilement d'au moins trois couches minces, dont une couche en matériau conducteur, se prolongeant jusqu'aux extrémités du filament, une couche en matériau catalyseur formant la zone d'interface et une couche intermédiaire en matériau électriquement isolant,
- l'élément résistif du filament est une couche d'un métal noble, notamment platine, or, palladium ou en une combinaison de métaux nobles,
- le filament a une conformation sinueuse, par exemple en créneau,
- la portion centrale du filament est reliée au substrat par un nombre de portions d'extrémité supérieur à deux,
- le substrat est choisi dans le groupe de matériaux constitué par le verre, le silicium, l'alumine, la silice, le quartz et les polymères,
- la zone d'interface est une couche mince déposée au moins sur l'une des faces du substrat à proximité de l'évidement.

L'invention propose également un procédé de préparation de filament faisant appel à des techniques de microélectronique, adapté à la fabrication du capteur précité et caractérisé en ce qu'il comporte les étapes suivantes :
- dépôt sur la surface des faces respectivement avant et arrière d'un substrat en forme de lame, d'une part, d'un masque avant en couche(s) mince(s) comportant un fenêtre avant dont la forme correspond à la forme du filament à fabriquer et comporte une portion centrale prolongée par des portions d'extrémité, et d'autre part, d'un masque arrière en couche(s) mince(s) comportant une fenêtre arrière située en regard de la portion centrale de la fenêtre à l'exclusion desdites extrémités, mais plus grande que cette portion centrale,
- creusement d'une tranchée dans le substrat par attaque de la face avant de celui-ci à travers le masque avant,
- dépôt au fond de cette tranchée d'une ou plusieurs couche(s) mince(s) destinée(s) à constituer le filament et dont l'une au moins est en matériau électriquement conducteur, et
- élimination du substrat sur toute son épaisseur par attaque à travers le masque arrière.

Selon des dispositions préférées :
- avant attaque du substrat pour son élimination sur toute son épaisseur à travers le masque arrière, on procède au dépôt d'une couche de protection sur la face avant et dans la tranchée et, après cette attaque du substrat, à l'élimination de cette couche de protection,
- la couche de protection de la face avant est une résine polymère,
- le masque avant comporte une couche intermédiaire recouverte d'une couche de résine, le dépôt de la (ou des) couche(s) mince(s) du filament étant obtenu, après élimination de la couche de résine, par dépôt d'une ou plusieurs couche(s) minces(s) dans la tranchée et autour de celle-ci puis élimination de la (ou des) couche(s) minces(s) déposée(s) en dehors de la tranchée par attaque de la couche intermédiaire.

Les principaux avantages qui découlent de l'invention sont, par rapport à tous les éléments détecteurs cités précédemment, une consommation électrique très faible, et un temps de réponse également très faible.

De réalisation automatisable et collective, le capteur peut être fabriqué d'une façon reproductible et en grande quantité à coût faible.

Sa résistance, ajustable en fonction de sa forme géométrique, permet une température de fonctionnement plus basse que les capteurs traditionnels à filament, ce qui entraîne une bonne résolution de la mesure, et un vieillissement moins rapide. Par suite de sa réalisation originale et grâce à la masse très faible qui en résulte, il est peu sensible aux chocs.

Du fait de son inertie thermique très faible, il peut permettre également d'éffectuer des mesures à des températures différentes et à des intervalles de temps très courts.

L'invention porte également sur l'application d'un tel capteur, principalement à la détection de gaz oxydable, tel que le méthane, ou CO, mais encore à la chromatographie gazeuse (détection de gaz ionisables) ou à la mesure de débits gazeux par calorimétrie.

Des objets, caractéristiques de l'invention ressortent de la description des dessins sur lesquels :
- la figure 1 est une vue en perspective d'un capteur selon l'invention,
- la figure 2 est une vue partielle en coupe longitudinale d'un autre capteur dans le sens de l'épaisseur,
- la figure 3 est une variante de la figure 1, et
- les figures 4 à 9 sont des vues en coupe du capteur de la figure 1 à divers stades de sa fabrication à partir d'un substrat selon le procédé de l'invention.

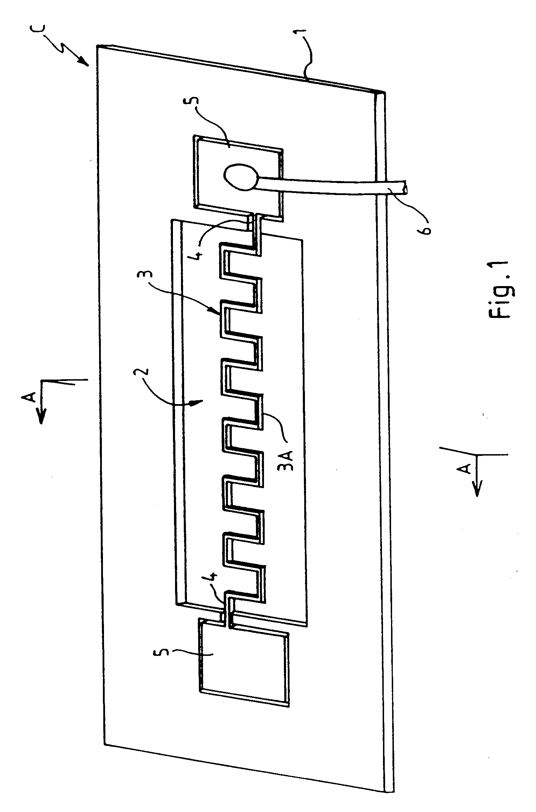

Le capteur C de la figure 1 comporte une lame isolante de support 1, en verre ou en un autre matériau isolant (voire semi-conducteur), traversée par un évidement 2. En variante cette lame de support peut être en un matériau, isolant ou non, recouvert d'une couche isolante.

En travers de l'évidement est disposé un filament 3 formé d'une couche mince en un matériau électriquement conducteur et dont la surface extérieure ou peau constitue une zone d'interface avec le milieu environnant.

Ce filament 3 comporte une portion centrale 3A et des extrémités 4 électriquement conductrices, par lesquelles cette portion centrale 3A est reliée à la lame de support. Ces extrémités se terminent par des plots conducteurs 5 auxquels peuvent être connectés, par exemple par soudure, des fils électriques 6 reliant le capteur au reste du circuit électrique le comportant.

Ce filament 3 a de préférence une conformation sinueuse parallèlement à la lame de support, ici en créneau ce qui, pour une section donnée, et un écartement donné entre les plots 5, lui confère une surface extérieure accrue et évite les risques de rupture par dilatation. D'autres conformations géométriques sont bien sûr possibles. Il est à préciser à ce propos que le filament en couche mince peut être non plus globalement rectiligne mais coudé parallèlement à la lame de support. Par ailleurs, le filament peut avoir la forme d'une fine lame parallèle à la lame de support, de dimensions bien sûr inférieures à celles de l'évidement.

La couche mince 3 peut être constituée par toute substance donnant lieu aux phénomènes physico-chimiques sur lesquels sont fondées les mesures; ainsi cette couche mince est ici réalisée en un matériau choisi comme ayant des propriétés électriques qui sont modifiées par l'environnement à caractériser.

Il peut en particulier s'agir pour la mesure de gaz oxydable d'un matériau catalytique : platine, nickel, osmium, or, irridium, combinaisons métalliques, oxydables métalliques, semi-conducteurs, sulfures ...

Ce matériau peut être également choisi en fonction de ses propriétés absorbantes ou adsorbantes dès lors qu'il en résulte une modification de ses caractéristiques électriques.

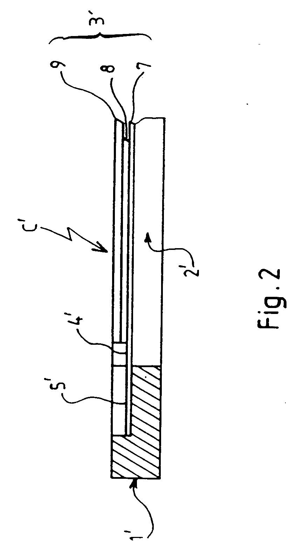

La figure 2 (où les éléments similaires à ceux de la figure 1 ont les mêmes signes de référence affectés de l'indice "prime") représente un autre capteur C′ dont le filament 3′ est constitué, non plus d'une seule couche mince, mais d'un empilement de couches minces en matériau conducteur, isolant ou catalyseur. La succession de ces couches est telle que :
- chaque couche en matériau catalyseur est située au-dessus ou en-dessous de l'empilement,
- chaque couche électriquement conductrice est reliée électriquement aux plots 5, et
- une couche isolante est prévue entre ces couches en matériau conducteur ou catalyseur.

Plus précisément, cette figure 2 représente trois couches successives 7, 8 et 9 respectivement en matériau conducteur, isolant et catalyseur. En variante non représentée l'empilement des couches est de type 9-8-7-8-9.

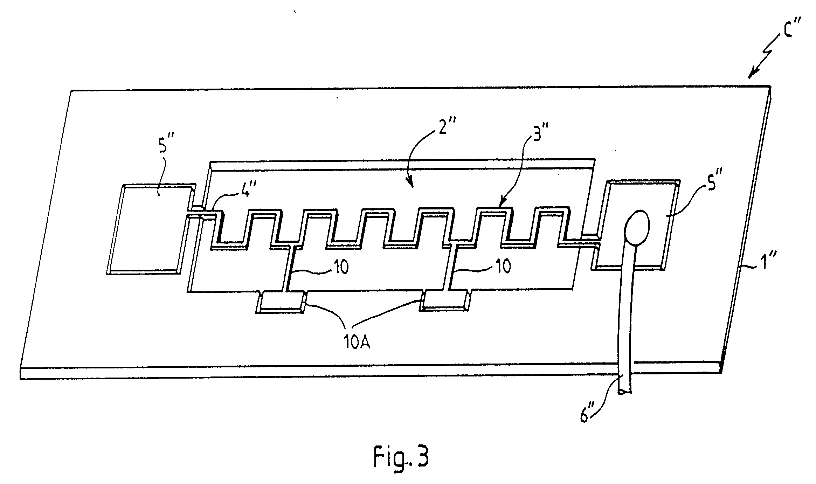

La figure 3 (où les éléments similaires à ceux de la figure 1 ont les mêmes signes de référence affectés de l'indice "seconde") représente une autre variante C˝ de la figure 1 dans laquelle des portions d'extrémité additionnelles 10 sont disposées transversalement à la portion centrale du filament 3˝. Ces portions additionnelles se terminent par des plots 10A. Ils peuvent, dans le cas d'un filament en une couche comme dans la figure 1, servir à des mesures électriques intermédiaires ou permettre des montages différents rendant possible de réduire le nombre de capteurs différents à fabriquer et stocker pour un nombre donné d'applications. Dans le cas d'un filament multicouche comme dans la figure 2, ces portions 10 peuvent constituer des liaisons électriques à la couche de catalyseur par ailleurs isolée par rapport à la couche conductrice.

On appréciera que dans chacun des exemples précités, l'ensemble du filament est entièrement situé dans l'encombrement (l'épaisseur) du substrat.

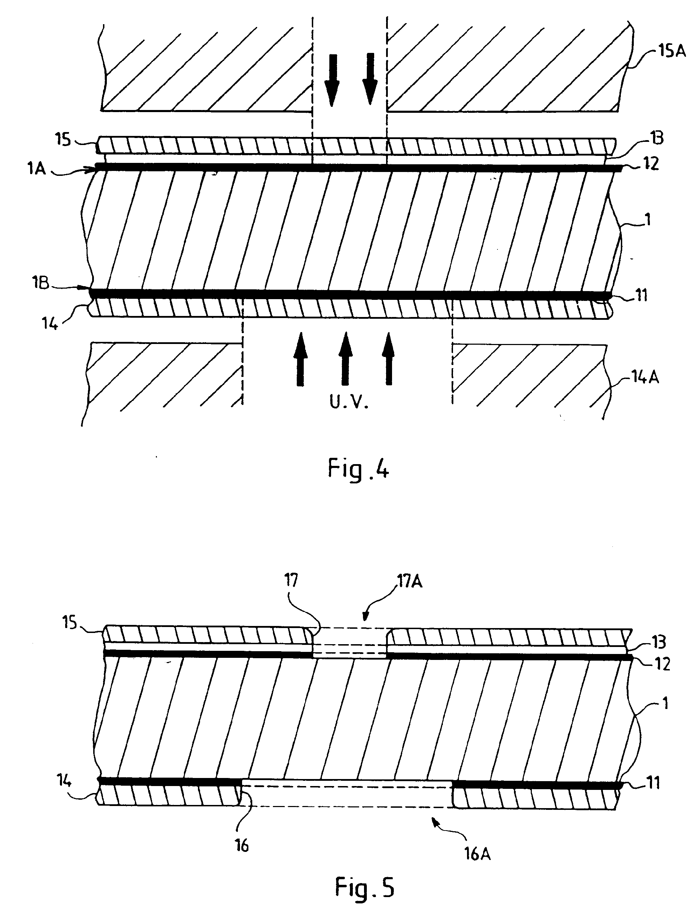

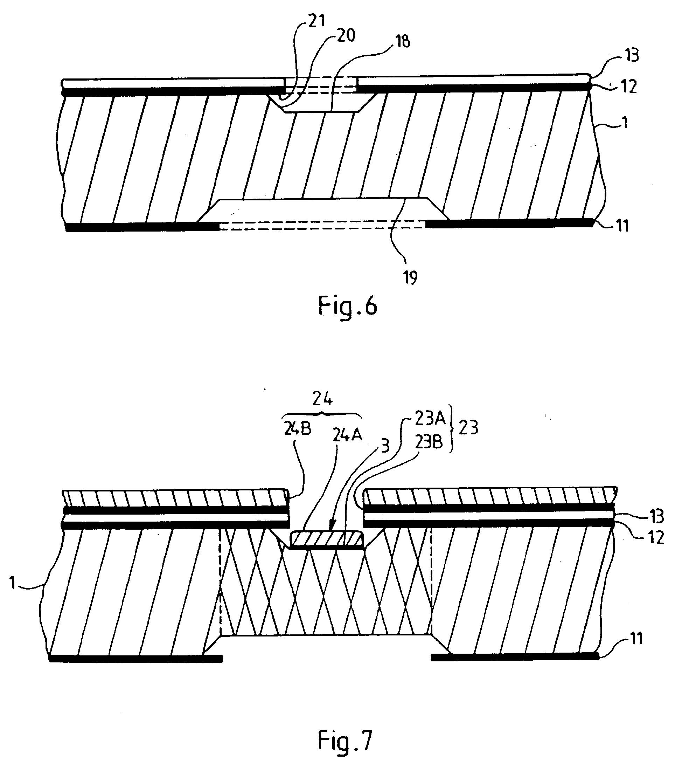

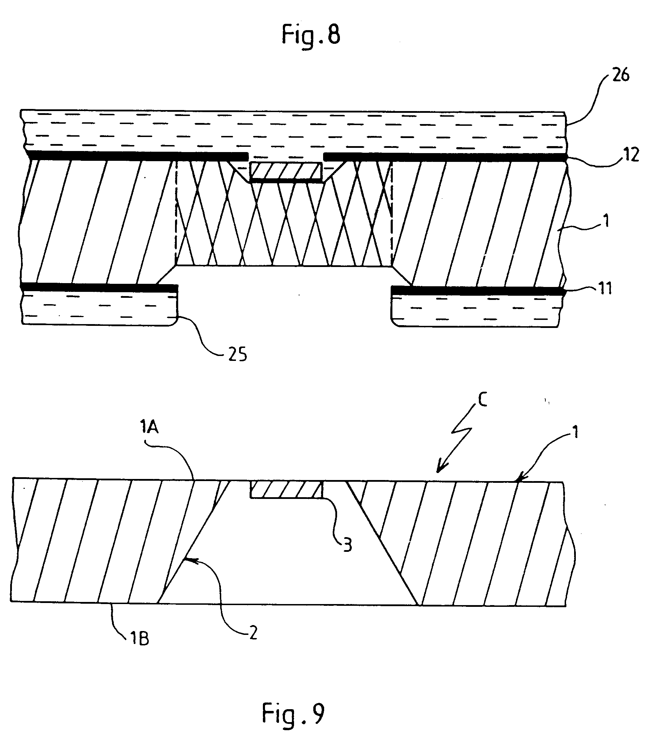

Les figures 4 à 9 représentent, dans un plan de coupe repéré A-A sur la figure 1, diverses étapes du procédé de fabrication du capteur 1, dans l'exemple considéré d'un substrat en verre :

Une première phase consiste à préparer le substrat 1 par :
- nettoyage du substrat 1 à l'acide nitrique ou sulfochromique par exemple puis rinçage à l'eau désionisée,
- séchage hors poussière.

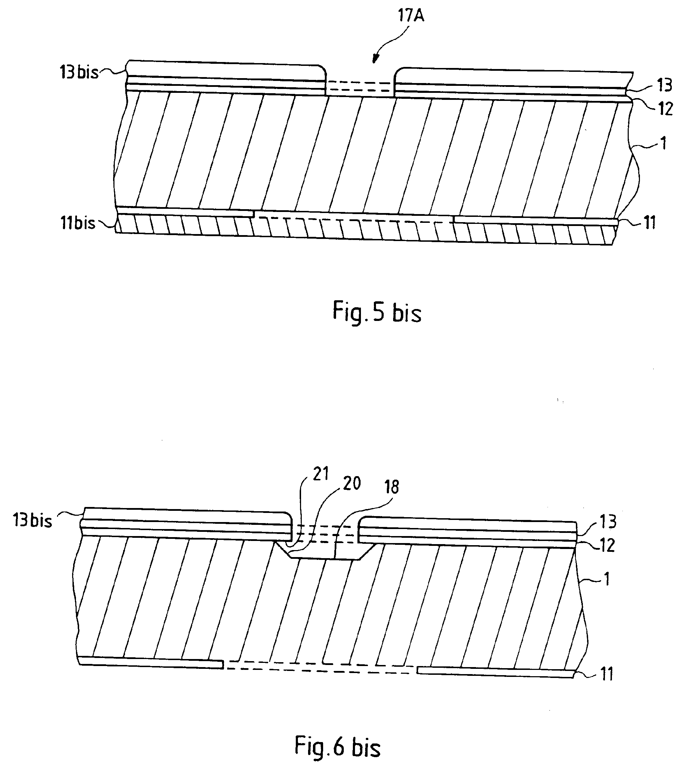

En une deuxième phase, on prépare des masques sur chacune des faces avant 1A et arrière 1B du substrat, avec les étapes suivantes (voir la figure 4) :
- une couche mince de chrome 11 de 1000 à 2000 Å est déposée sur la face arrière; sur l'autre face (face avant), une couche de chrome 12 de quelques Å à 1000 Å puis une couche d'or 13 de 1000 Å environ sont déposées. Les étapes peuvent être différées l'une par rapport à l'autre mais sont de préférence simultanées.
- une couche de résine photosensible 14, 15 est déposée sur chaque face du substrat,
- on positionne des masques d'insolation 14A et 15A en vis-à-vis de part et d'autre du substrat et des couches précitées, on procède à l'insolation des couches 14 et 15 au travers des masques 14A et 15A, et on développe les zones ainsi insolées : on obtient ainsi des masques de résine 16 et 17. Les deux dernières étapes sont tout à fait classiques en soi.
- on grave les couches métalliques au travers des masques 16 et 17,
   . gravure de la couche de chrome 11 sur la face arrière,
   . gravure de la couche d'or 13 sur la face avant,
   . gravure de la couche de chrome 12 en face avant.
- nouveau rinçage à l'eau désionisée; on obtient ainsi la structure de la figure 5.

On appréciera que le masque arrière ainsi obtenu (couches 11 et 14) comporte une fenêtre 16A située en regard de la portion centrale (entre les extrémités 4 et 5 de la figure 1) de la fenêtre 17A du masque avant (couches 12, 13 et 15) à l'exclusion desdites extrémités, mais cette fenêtre 16A est plus grande (ici plus large de chaque côté) que cette portion centrale.

Dans une troisième phase, on procède au creusement de tranchées 18 et 19 par attaque chimique du verre avec de l'acide fluorhydrique à travers les masques constitués des couches superposées de chrome 12, d'or 13 et de résine 15, gravées sur la face avant 1A de la lame 1. Cette attaque chimique est isotrope (dans le sens de l'épaisseur et latéralement); il en résulte une surgravure dégageant les couches 12 et 13 au-dessus des bords inclinés 20 de la tranchée formant ainsi un surplomb 21. Alors qu'il est d'usage dans les procédés de gravure de ce type d'en modifier les conditions pour éviter la surgravure, ici on recherche et utilise précisément cette surgravure. En effet, le surplomb 21 qui en résulte permet une meilleure élimination des couches 12 et 13 en fin de fabrication.

Les masques de résine 14 et 15 sont éliminés par exemple dans l'acétone puis dans l'acide nitrique. On effectue ensuite un rinçage à l'eau désionisée et un séchage hors poussière : on obtient la structure de la figure 6.

Dans une quatrième étape, on élabore le filament 3 au fond de la tranchée 18 par dépôt d'une fine couche de chrome 23 (100 Å environ) sur la face avant 1A du substrat y compris au fond de la tranchée 18 puis, par dépôt sur toute cette couche mince 23 d'une couche de platine 24 (voir figure 7). On obtient ainsi dans la tranchée des couches minces 23A et 24A dissociées des portions 23B et 24B d'or et de platine déposées sur le reste de la face avant. L'épaisseur globale des couches 23 et 24 doit donc être inférieure (au moins légèrement) à la profondeur de la tranchée 18. Dans le cas du capteur C' de la figure 2, la condition équivalente consiste à dire que l'épaisseur globale des couches déposées est inférieure à la profondeur de la tranchée. Il est essentiel que les couches dans la tranchée 18 ne viennent pas au contact des surplombs 21.

On procède ensuite à l'élimination des portions latérales 24A et 23A des couches de platine et de chrome en excès par attaque chimique de la couche d'or 13 (immersion du substrat pendant au moins 3 heures dans un réactif de gravure de l'or ce qui élimine mécaniquement la couche superflue de platine, et décollement des dernières traces de platine en excès dans un bac à ultra-sons). Cette opération est grandement facilitée par le surplomb 21 obtenu par surgravure.

Après rinçage à l'eau désionisée et séchage, une nouvelle couche 25 en résine photosensible de 3»m environ est déposée sur la face arrière puis est soumise à une insolation à travers le même masque qu'à la figure 4 : après développement, on obtient un masque arrière en coïncidence avec le masque en chrome 11 resté sur cette face; en pratique, on procède ensuite au recuit du masque à 140°C (pendant 30 mn).

Dans une dernière phase, on creuse le substrat sur toute son épaisseur par attaque au travers du masque arrière selon les étapes suivantes :
- dépôt d'une couche de protection 26 sur la face avant 1A revêtue de la couche de chrome 12. Cette couche de protection remplit la cuvette 18 et en y adhérant recouvre le filament au fond de cette dernière. Cette couche de protection peut être constituée de tout matériau résistant à l'acide fluorhydrique et pouvant facilement être mis en solution à l'aide d'un solvant du commerce. On utilise de manière préférentielle une résine polymère du type APIEZON-W de ZIVY,
- attaque chimique sous ultra-sons du verre 1 portant le filament à travers le masque 25 déposé sur la face arrière 1B et constitué de la couche de chrome 11 et de la couche de résine photosensible 25 gravées.

Après élimination du verre et de la couche de protection 26 à l'aide d'un solvant du commerce approprié; par exemple du perchloréthylène, le filament 3 reste d'une manière inattendue "autoporté" dans la lame de verre (voir figure 9). Cette dernière est dégagée d'une part de toute présence de résine ou de polymère à l'aide d'un réactif chimique adapté (acide nitrique fumant en général) et, d'autre part, des couches de chrome 11 et 12 subsistant sur chaque face de la lame de verre à l'aide du réactif de gravure chimique du chrome.

L'inclinaison des flancs de l'évidement 2 de la figure 9 provient du caractère isotrope de l'attaque fluorhydrique. Dans le cas d'un substrat et d'un acide d'attaque conduisant à une attaque anisotrope, on obtiendrait des flancs verticaux comme cela est représenté aux figures 7 et 8.

A titre d'exemple les réactifs de gravure chimique utilisés sont :
. chrome :
   1) Cr-ETCH de SOPRELEC (EVRY)
   2) 50g/l de KMnO4 + 50g/l de KOH + eau désionisée (1l),
. or : 25g/l de I₂ = 60g/l de KI + 1 litre d'eau désionisée,
. verre : HF dilué de 40% à 20% (suivant la vitesse de gravure désirée).

Des exemples d'épaisseurs pour des lames de verre de 150 »m d'épaisseur sont :
. chrome N° 11 : 500 Å à 1000 Å
. chrome N°^{s} 12 et 23 : 50 Å à 500 Å
. or N° 13 : 1500 Å à 2500 Å
. platine : 0,5 »m à 9 »m
. apiézon W : minimum 100 »m
. résine photosensible 1350-H de SHIPPLEY : 1 à 3 »m
. longueur de l'évidement : 2 mm.

L'intérêt des couches de chrome réside d'une part, dans l'amélioration du dépôt d'or qui ne pourrait pas se faire directement sur le verre, d'autre part, dans la bonne tenue du masque constitué pas les couches de résine photosensible et les couches de chrome lors des attaques fluorhydriques du verre.

Une variante du procédé consiste à réaliser selon les figures 5bis et 6bis une opération d'épaississement de la couche d'or. Cette variante permet ainsi de déposer une épaisseur de platine plus importante.

Les deuxième et troisième phases du procédé sont modifiées ainsi :

A l'issue des gravures métalliques au travers des masques 16 et 17 on procède à :
- un décapage des couches de résines 14 et 15 à l'acétone et à l'acide nitrique
- puis à un nouveau rinçage à l'eau désionisée.

On appréciera que le masque arrière ainsi obtenu (couche 11) comporte une fenêtre 16A située en regard de la portion centrale (entre les extrémités 4 de la figure 1) de la fenêtre 17A du masque avant (couches 12, 13) à l'exclusion desdites extrémités, mais cette fenêtre 16A est plus grande (ici plus large de chaque côté) que cette portion centrale.

On procède ensuite à une opération d'épaississement de la couche d'or 13 (figure 5bis) par dépôt électrolytique d'or (couche 13bis) suivie d'un rinçage à l'eau désionisée.

L'épaisseur d'or électrolytique est déterminée par la profondeur des tranchées que l'on va graver dans l'étape suivante soit environ 1»m pour une profondeur de tranchée de 10 à 15 »m. On dépose sur la face arrière une couche uniforme de résine photosensible de protection 11bis.

Dans la troisième phase, on procède au creusement de la tranchée 18 par attaque chimique du verre avec de l'acide fluorhydrique à travers le masque constitué des couches superposées de chrome 12, d'or 13 et 13bis, gravées sur la face avant 1A de la lame 1. Cette attaque chimique est isotrope (dans le sens de l'épaisseur et latéralement); il en résulte une surgravure dégageant les couches 12, 13 et 13bis au-dessus des bords inclinés 20 de la tranchée formant ainsi un surplomb 21. Alors qu'il est d'usage dans les procédés de gravure de ce type d'en modifier les conditions pour éviter la surgravure, ici on recherche et utilise précisément cette surgravure. En effet, le surplomb 21 qui en résulte permet une meilleure élimination des couches 12 et 13 en fin de fabrication.

Le masque de résine 11bis est éliminé par exemple dans l'acétone puis dans l'acide nitrique. On effectue ensuite un rinçage à l'eau désionisée et un séchage hors poussière : on obtient la structure de la figure 6.

Les phases ultérieures du procédé restent identiques.

En dehors du verre, il est possible d'utiliser d'autres substrats : le silicium, l'alumine, la silice et en particulier le quartz qui offre une bonne tenue à la température et une résistance sélective aux attaques chimiques.

De même, il est également possible d'employer des substrats métallisés double face, par exemple or sur chrome, ceci permettant de supprimer les étapes initiales de dépôts métalliques.

Ainsi, des essais ont été réalisés sur du quartz d'épaisseur comprise entre 125 »m et 175 »m, métallisé double face or sur chrome en utilisant les mêmes réactifs de gravure chimique.

Un tel capteur se prête à diverses applications.

Ainsi tout d'abord il peut servir à la détection de gaz oxydable par intégration d'un circuit connu décrit.

Il peut aussi servir à des mesures par chromatographie : le filament 3 sert à échauffer et ioniser localement le milieu gazeux et une ou plusieurs électrodes de réception d'ions (zone d'interface) sont constituées par une ou plusieurs couches minces conductrices déposées sur le substrat auprès de l'évidement 2 : il peut s'agir des couches de chrome 11 et 12 que l'on laisse subsister à cet effet.

Il va de soi que la présente invention n'a été proposée qu'à titre d'exemple non limitatif et que de nombreuses variantes peuvent être proposées par l'homme de l'art sans sortir du cadre de l'invention. Ainsi plusieurs filaments peuvent être formés dans un même évidement et plusieurs évidements peuvent être formés à la fois dans un même substrat (fabrication collective).

## Revendications

1. Capteur à filament pour la détermination d'une caractéristique statique ou dynamique d'un milieu environnant, comportant un élément résistif destiné à être chauffé par effet JOULE dans ce milieu, et une zone d'interface adaptée à réagir avec ce milieu selon un processus physico-chimique influant, en fonction de la caractéristique à déterminer, sur une caractéristique électrique de cette zone d'interface, caractérisé en ce qu'il comporte une lame de support (1, 1′, 1˝) traversée par au moins un évidement (2, 2′, 2˝) et au moins un filament (3, 3′, 3˝) incluant cet élément résistif, constitué d'une ou plusieurs couche(s) mince(s) (3, 7, 8, 9, 24A) et comportant une portion centrale s'étendant librement dans l'évidement et au moins deux portions d'extrémité (4, 4′, 4˝, 10) par lesquelles cette portion centrale est reliée à la lame de support, grâce à quoi ce filament est autoporté.

2. Capteur selon la revendication 1, caractérisé en ce que le filament (3, 3˝) est formé d'une couche en matériau métallique catalytique dont la surface extérieure constitue ladite zone d'interface.

3. Capteur selon la revendication 1, caractérisé en ce que le filament, au moins dans sa portion centrale, est formé d'un empilement d'au moins trois couches minces (7, 8, 9) dont une couche (7) en matériau conducteur, se prolongeant jusqu'aux extrémités du filament, une couche (9) en matériau catalyseur formant la zone d'interface et une couche intermédiaire (8) en matériau électriquement isolant.

4. Capteur selon l'une quelconque des revendications 1 à 3, caractérisé en ce que l'élément résistif est une couche d'un métal noble, notamment platine, or, palladium ou en une combinaison de métaux nobles.

5. Capteur selon l'une quelconque des revendications 1 à 4, caractérisé en ce que le filament a une conformation sinueuse.

6. Capteur selon l'une quelconque des revendications 1 à 5, caractérisé en ce que la portion centrale du filament est reliée au substrat par un nombre de portions d'extrémités (4˝, 10) supérieur à deux.

7. Capteur selon l'une quelconque des revendications 1 à 6, caractérisé en ce que le substrat est choisi dans le groupe de matériaux constitué par le verre, le silicium, l'alumine, la silice, le quartz et les polymères.

8. Application du capteur selon l'une quelconque des revendications 1 à 7 à la détection de gaz oxydable.

9. Application du capteur selon la revendication 8, caractérisée en ce que le gaz oxydable est du méthane ou du monoxyde de carbone.

10. Application du capteur selon l'une quelconque des revendications 1 à 7 à la mesure de débits de fluides.

11. Capteur selon la revendication 1, caractérisé en ce que la zone d'interface est une couche mince déposée au moins sur l'une des faces du substrat à proximité de l'évidement.

12. Application du capteur selon la revendication 11, à la détection et à la mesure de gaz ionisable par chromatographie par ionisation.

13. Procédé de fabrication d'un capteur à filament pour la détermination d'une caractéristique statique ou dynamique d'un milieu environnant, comportant un élément résistif destiné à être chauffé par effet JOULE dans ce milieu, et une zone d'interface adaptée à réagir avec ce milieu selon un processus physico-chimique influant, en fonction de la caractéristique à déterminer, sur une caractéristique électrique de cette zone d'interface, adapté à la fabrication d'un capteur selon l'une quelconque des revendications 1 à 12, caractérisé en ce qu'il comporte les étapes suivantes :
- dépôt sur la surface des faces respectivement avant (1A) et arrière (1B) d'un substrat en forme de lame (1), d'une part, d'un masque avant en couche(s) mince(s) (12, 13, 15) comportant une fenêtre avant (17A) dont la forme correspond à la forme du filament (3) à fabriquer et comporte une portion centrale prolongée par des portions d'extrémité, et d'autre part, d'un masque arrière en couche(s) mince(s) (11, 14) comportant une fenêtre arrière (16A) située en regard de la portion centrale de la fenêtre à l'exclusion desdites extrémités, mais plus grande que cette portion centrale,
- creusement d'une tranchée (18) dans le substrat par attaque de la face avant de celui-ci à travers le masque avant,
- dépôt au fond de cette tranchée d'une ou plusieurs couche(s) mince(s) (24A) destinée(s) à constituer le filament et dont l'une au moins est en matériau électriquement conducteur, et
- élimination du substrat sur toute son épaisseur par attaque à travers un masque (11, 25) de même forme que le masque arrière.

14. Procédé de fabrication d'un capteur à filament pour la détermination d'une caractéristique statique ou dynamique d'un milieu environnant, comportant un élément résistif destiné à être chauffé par effet JOULE dans ce milieu, et une zone d'interface adaptée à réagir avec ce milieu selon un processus physico-chimique influant, en fonction de la caractéristique à déterminer, sur une caractéristique électrique de cette zone d'interface, adapté à la fabrication d'un capteur selon l'une quelconque des revendications 1 à 12, caractérisé en ce qu'il comporte les étapes suivantes :
- dépôt sur la surface des faces respectivement avant (1A) et arrière (1B) d'un substrat en forme de lame (1), d'une part, d'un masque avant en couche(s) mince(s) (12, 13) et d'un dépôt électrolytique (13bis) comportant une fenêtre avant (17A) dont la forme correspond à la forme du filament (3) à fabriquer et comporte une portion centrale prolongée par des portions d'extrémité, et d'autre part, d'un masque arrière en couche(s) mince(s) (11, 11bis) comportant une fenêtre arrière (16A) située en regard de la portion centrale de la fenêtre à l'exclusion desdites extrémités, mais plus grande que cette portion centrale,
- creusement d'une tranchée (18) dans le substrat par attaque de la face avant de celui-ci à travers le masque avant,
- dépôt au fond de cette tranchée d'une ou plusieurs couche(s) mince(s) (24A) destinée(s) à constituer le filament et dont l'une au moins est en matériau électriquement conducteur, et
- élimination du substrat sur toute son épaisseur par attaque à travers un masque (11, 25) de même forme que le masque arrière.

15. Procédé de fabrication d'un capteur à filament pour la détermination d'une caractéristique statique ou dynamique d'un milieu environnant, comportant un élément résistif destiné à être chauffé par effet JOULE dans ce milieu, et une zone d'interface adaptée à réagir avec ce milieu selon un processus physico-chimique influant, en fonction de la caractéristique à déterminer, sur une caractéristique électrique de cette zone d'interface, adapté à la fabrication d'un capteur selon l'une quelconque des revendications 1 à 12, caractérisé en ce l'on utilise un substrat métallisé comportant une fenêtre avant (17A) dont la forme correspond à celle du filament (3) à fabriquer et comporte une portion centrale prolongée par des portions d'extrémités et d'autre part, une fenêtre arrière (16A) située en regard de la portion centrale de la fenêtre à l'exclusion desdites extrémités mais plus grande que cette portion centrale,
- on creuse une tranchée (18) dans le substrat par attaque de la face avant de celui-ci à travers le masque avant,
- on dépose au fond de cette tranchée une ou plusieurs couche(s) mince(s) (24A) destinée(s) à constituer le filament et dont l'une au moins est en matériau électriquement conducteur, et
- on élimine le substrat sur toute son épaisseur par attaque à travers un masque (11, 25) de même forme que le masque arrière.

16. Procédé selon l'une quelconque des revendications 13 à 15, caractérisé en ce qu'il comporte, avant attaque du substrat pour son élimination sur toute son épaisseur à travers le masque arrière, le dépôt d'une couche de protection (26) sur la face avant et dans la tranchée et, après cette attaque du substrat, élimination de cette couche de protection.

17. Procédé selon la revendication 16, caractérisé en ce que la couche de protection de la face avant est une résine polymère.

18. Procédé selon l'une quelconque des revendications 13 à 17, caractérisé en ce que le masque avant comporte une couche intermédiaire (13) recouverte d'une couche de résine (15), le dépôt de la (ou des) couche(s) mince(s) du filament étant obtenu, après élimination de la couche de résine (15), par dépôt d'une ou plusieurs couche(s) mince(s) (24) dans la tranchée (24A) et autour de celle-ci (24B) puis élimination de la (ou des) couche(s) mince(s) (24B) déposée(s) en dehors de la tranchée par attaque de la couche intermédiaire.

19. Procédé selon la revendication 18, caractérisé en ce que, le substrat étant en verre, le masque avant comporte une couche d'or (13) recouvrant une couche de chrome (12) déposée sur la face avant (1A), et on dépose au moins une couche de platine au fond de la tranchée avant (18).

20. Procédé selon l'une quelconque des revendications 13 à 19, caractérisé en ce qu'on dépose dans la tranchée avant au moins une couche en matériau métallique catalytique.

21. Procédé selon l'une quelconque des revendications 13 à 20, caractérisé en ce qu'on dépose au moins trois couches minces (7, 8, 9) au fond de la tranchée, dont une couche en matériau conducteur, une couche en matériau isolant et une couche en matériau catalyseur.

22. Procédé selon l'une quelconque des revendications 13 à 21, caractérisé en ce que le substrat est choisi dans le groupe de matériaux constitué par le verre, le silicium, l'alumine, la silice, le quartz et les polymères.

## Patentansprüche

1. Fadensensor zur Bestimmung einer statischen oder dynamischen Eigenschaft eines umgebenden Mediums, umfassend ein resistives Element das dazu bestimmt ist, mittels JOULE-Effekt in diesem Medium erhitzt zu werden, und eine Zwischenflächenzone, die ausgelegt ist, mit dem Medium nach einem beeinflussenden physikalisch-chemischen Prozess in Abhängigkeit von der zu bestimmenden Eigenschaft auf eine elektrische Eigenschaft dieser Zwischenflächenzone zu reagieren, dadurch gekennzeichnet, daß er ein Trägerblatt (1, 1′, 1˝) aufweist, das von mindestens einer Aussparung (2, 2′, 2˝) und mindestens einem dieses resistive Element einschließenden Faden (3, 3′, 3˝) durchquert wird, der aus einer oder mehreren dünnen Schichten (3, 7, 8, 9, 24A) besteht und einen zentralen Abschnitt aufweist, der sich frei in der Aussparung erstreckt, und mindestens zwei Endabschnitte (4, 4′, 4˝, 10) aufweist durch welche der zentrale Abschnitt mit der Trägerblatt verbunden ist, wodurch der Faden selbsttragend ist.

2. Sensor nach Anspruch 1, dadurch gekennzeichnet, daß der Faden (3, 3˝) aus einer Schicht von metallischem Katalysatormaterial gebildet ist, dessen Außenfläche die Zwischenflächenzone darstellt.

3. Sensor nach Anspruch 1, dadurch gekennzeichnet, daß der Faden zumindest in einem zentralen Abschnitt aus einem Stapel von mindestens drei dünnen Schichten (7, 8, 9) gebildet ist, von denen eine Schicht (7) aus leitendem Material sich bis zu den äußeren Fadenenden erstreckt, eine Schicht (9) aus Katalysatormaterial die Zwischenflächenzone bildet, und eine Zwischenschicht (8) aus elektrisch isolierendem Material besteht.

4. Sensor nach einem der Ansprüche 1 bis 3, dadurch gekennzeichnet, daß das resistive Element eine Schicht aus einem Edelmetall, insbesondere Platin, Gold, Palladium, oder einer Kombination von Edelmetallen ist.

5. Sensor nach einem der Ansprüche 1 bis 4, dadurch gekennzeichnet, daß der Faden eine gewundene Formgebung hat.

6. Sensor nach einem der Ansprüche 1 bis 5, dadurch gekennzeichnet, daß der zentrale Abschnitt des Fadens durch eine Anzahl von mehr als zwei Endabschnitten (4˝, 10) mit dem Substrat verbunden ist.

7. Sensor nach einem der Ansprüche 1 bis 6, dadurch gekennzeichnet, daß das Substrat aus der Gruppe von Materialien ausgewählt ist, die aus Glas, Silicium, Tonerde (Aluminiumoxid), Kieselerde (Siliciumdioxid), Quarz und Polymeren besteht.

8. Verwendung eines Sensors nach einem der Ansprüche 1 bis 7 zur Feststellung von oxidierbarem Gas.

9. Verwendung eines Sensors nach Anspruch 8, dadurch gekennzeichnet, daß das oxidierbare Gas Methan oder Kohlenmonoxid ist.

10. Verwendung eines Sensors nach einem der Ansprüche 1 bis 7 zum Messen des Ausstoßes von Flüssigkeiten.

11. Sensor nach Anspruch 1, dadurch gekennzeichnet, daß die Zwischenflächenzone eine dünne Schicht ist, die auf mindestens eine der Substratoberflächen nahe der Aussparung abgeschieden ist.

12. Verwendung eines Sensors nach Anspruch 11 zum Feststellen und Messen von ionisierbarem Gas durch Ionisationschromatographie.

13. Verfahren zur Herstellung eines Fadensensors zum Bestimmen einer statischen oder dynamischen Eigenschaft eines umgebenden Mediums, umfassend ein resistives Element, das dazu bestimmt ist, mittels JOULE-Effekt in diesem Medium erhitzt zu werden, und eine Zwischenflächenzone, die ausgelegt ist, mit dem Medium nach einem beeinflussenden physikalisch-chemischen Prozess in Abhängigkeit von der zu bestimmenden Eigenschaft auf eine elektrische Eigenschaft dieser Zwischenflächenzone zu reagieren, das zur Herstellung eines Sensors nach einem der Ansprüche 1 bis 12 geeignet ist, dadurch gekennzeichnet, daß es die folgenden Schritte beinhaltet:
- Abscheiden auf der Oberfläche der jeweiligen Vorderseite (1A) und Rückseite (1B) eines blattförmigen Substrates (1) einerseits einer vorderen Maske in einer oder mehreren dünnen Schichten (12, 13, 15), die ein vorderes Fenster (17A) aufweist, dessen Form der Form des herzustellenden Fadens (3) entspricht und einen durch die Endabschnitte verlängerten zentralen Abschnitt aufweist, und andererseits einer rückseitigen Maske in einer oder mehreren dünnen Schichten (11, 14), die ein rückseitiges Fenster (16A) aufweist, das mit Bezug zum zentralen Abschnitt des Fensters unter Ausschluß der Enden angeordnet, aber größer als dieser zentrale Abschnitt ist,
- Eintiefen eines Einschnittes (18) in das Substrat durch Angriff der Vorderseite desselben durch die vordere Maske hindurch,
- Abscheiden einer oder mehrerer dünner Schichten (24A) am Boden des Einschnittes, die dazu bestimmt sind, einen Faden zu bilden, und von denen mindestens eine aus elektrisch leitendem Material besteht, und
- Entfernen des Substrates auf seiner gesamten Dicke durch Angriff durch eine Maske (11, 25) hindurch, die die gleiche Form wie die vordere Maske hat.

14. Verfahren zur Herstellung eines Fadensensors zum Bestimmen einer statischen oder dynamischen Eigenschaft eines umgebenden Mediums, umfassend ein resistives Element, das dazu bestimmt ist, mittels JOULE-Effekt in diesem Medium erhitzt zu werden, und eine Zwischenflächenzone, die ausgelegt ist, mit dem Medium nach einem beeinflussenden physikalisch-chemischen Prozess in Abhängigkeit von der zu bestimmenden Eigenschaft auf eine elektrische Eigenschaft dieser Zwischenflächenzone zu reagieren, das zur Herstellung eines Sensors nach einem der Ansprüche 1 bis 12 geeignet ist, dadurch gekennzeichnet, daß es die folgenden Schritte beinhaltet:
- Abscheiden auf der Oberfläche der jeweiligen Vorderseite (1A) und Rückseite (1B) eines blattförmigen Substrates (1) einerseits einer vorderen Maske in einer oder mehreren dünnen Schichten (12, 13) und eines Elektrolytniederschlages (13bis), die ein vorderes Fenster (17A) aufweisen, dessen Form der Form des herzustellenden Fadens (3) entspricht, und einen durch die Endabschnitte verlängerten zentralen Abschnitt aufweisen, und andererseits einer rückseitigen Maske in einer oder mehreren dünnen Schichten (11, llbis), die ein rückseitiges Fenster (16A) aufweist, das mit Bezug zum zentralen Abschnitt des Fensters unter Ausschluß der Enden angeordnet, aber größer als dieser zentrale Abschnitt ist,
- Eintiefen eines Einschnittes (18) in das Substrat durch Angriff der Vorderseite desselben durch die vordere Maske hindurch,
- Abscheiden einer oder mehrerer dünner Schichten (24A) am Boden des Einschnittes, die dazu bestimmt sind, den Faden darzustellen, und von denen mindestens eine aus elektrisch leitendem Material besteht, und
- Entfernen des Substrates auf seiner gesamten Dicke durch Angriff durch eine Maske (11, 25) hindurch, die die gleiche Form wie die vordere Maske hat.

15. Verfahren zur Herstellung eines Fadensensors zum Bestimmen einer statischen oder dynamischen Eigenschaft eines umgebenden Mediums, umfassend ein resistives Element, das dazu bestimmt ist, mittels JOULE-Effekt in diesem Medium erhitzt zu werden, und eine Zwischenflächenzone, die ausgelegt ist, mit dem Medium nach einem beeinflussenden physikalisch-chemischen Prozess in Abhängigkeit von der zu bestimmenden Eigenschaft auf eine elektrische Eigenschaft dieser Zwischenflächenzone zu reagieren, das zur Herstellung eines Sensors nach einem der Ansprüche 1 bis 12 geeignet ist, dadurch gekennzeichnet, daß man ein metallisiertes Substrat verwendet, das ein vorderes Fenster (17A) aufweist, dessen Form derjenigen des herzustellenden Fadens (3) entspricht und das einen durch die Endabschnitte verlängerten zentralen Abschnitt aufweist, und andererseits ein rückseitiges Fenster (16A) aufweist, das in Bezug zum zentralen Abschnitt des Fensters unter Ausschluß der Enden angeordnet, jedoch größer als dieser zentrale Abschnitt ist,
- man eine Eintiefung (18) durch Angriff der vorderen Seite des Substrates durch die vordere Maske hindruch in das Substrat einschneidet,
- man am Boden der Eintiefung eine oder mehrere dünne Schichten (24A) abscheidet, die den Faden darstellen sollen und von denen mindestens eines aus elektrisch leitendem Material besteht, und
- man das Substrat auf seiner gesamten Dicke durch Angriff durch eine Maske (11, 25) hindurch entfernt, die die gleiche Form wie die rückseitige Maske hat.

16. Verfahren nach einem der Ansprüche 13 bis 15, dadurch gekennzeichnet, daß es vor dem Angriff des Substrates zu dessen Entfernung auf seiner gesamten Dicke durch die rückseitige Maske hindurch das Abscheiden einer Schutzschicht (26) auf der Vorderseite und in dem Einschnitt aufweist, worauf diese Schutzschicht nach dem Angriff des Substrates entfernt wird.

17. Verfahren nach Anspruch 16, dadurch gekennzeichnet, daß die Schutzschicht der Vorderseite aus einem Polymerharz besteht.

18. Verfahren nach einem der Ansprüche 13 bis 17, dadurch gekennzeichnet daß die vordere Maske eine Zwischenschicht (13) aufweist, die von einer Harzschicht (15) bedeckt ist, wobei die Abscheidung einer oder mehrerer dünner Schichten des Fadens nach Entfernen der Harzschicht (15) durch Abscheiden einer oder mehrerer dünner Schichten (24) in dem Einschnitt (24A) und um diesen herum (24B) erhalten wird, worauf eine oder mehrere dünne Schichten (24B), die um den Einschnitt abgeschieden wurden, durch Angriff der Zwischenschicht entfernt werden.

19. Verfahren nach Anspruch 18, dadurch gekennzeichnet, daß dann, wenn das Substrat aus Glas besteht, die vordere Maske eine Schicht aus Gold (13) aufweist, die eine auf der Vorderseite (1A) abgeschiedene Schicht aus Chrom (12) bedeckt, und man mindestens eine Schicht aus Platin am Boden des vorderen Einschnittes (18) abscheidet.

20. Verfahren nach einem der Ansprüche 13 bis 19, dadurch gekennzeichnet, daß man in den vorderen Einschnitt mindestens eine Schicht aus metallischem Katalysatormaterial abscheidet.

21. Verfahren nach einem der Ansprüche 13 bis 20, dadurch gekennzeichnet, daß man am Boden des Einschnittes mindestens drei dünne Schichten (7, 8, 9) abscheidet, von denen eine Schicht aus Leitermaterial, eine Schicht aus isolierendem Material und eine Schicht aus Katalysatormaterial besteht.

22. Verfahren nach einem der Ansprüche 13 bis 21, dadurch gekennzeichnet, daß das Substrat aus der Gruppe von Materialien ausgewählt ist, die aus Glas, Silicium, Tonerde (Aluminiumoxid), Kieselerde (Siliciumoxid), Quarz und Polymeren besteht.

## Claims

1. Filament type sensor for determining a static or dynamic characteristic of a surrounding environment, comprising a resistive element adapted to be heated in the environment by the JOULE effect and an interface area adapted to react with the environment in a physico-chemical process influencing an electrical characteristic of the interface area according to the characteristic to be determined, characterised in that it comprises a supporting wafer (1, 1′, 1˝) through which there is formed at least one hole (2, 2′, 2˝) and at least one filament (3, 3′, 3˝) including the resistive element, comprising one or more thin films (3, 7, 8, 9, 24A) and having a central portion situated in the hole and at least two end portions (4, 4′, 4˝, 10) by which the central portion is connected to the supporting wafer, so that the filament is self-supported.

2. Sensor according to claim 1 characterised in that the filament (3, 3˝) is formed by a film of a metal catalyst whose exterior surface constitutes said interface area.

3. Sensor according to claim 1 characterised in that at least the central portion of the filament is formed by at least three superposed thin films (7, 8, 9) comprising a conductive material film (7) extending to the ends of the filament, a catalyst film (9) forming the interface area and an electrically insulative material intermediate film (8).

4. Sensor according to any one of claims 1 to 3 characterised in that the resistive element is a film of a noble metal such as platinum, gold or palladium or a combination of noble metals.

5. Sensor according to any one of claims 1 to 4 characterised in that the filament has a sinuous shape.

6. Sensor according to any one of claims 1 to 5 characterised in that the central portion of the filament is connected to the substrate by more than two end portions (4˝, 10).

7. Sensor according to any one of claims 1 to 6 characterised in that the substrate is chosen from the group of materials comprising glass, silicon, alumina, silica, quartz and polymers.

8. Application of the sensor according to any one of claims 1 to 7 to the detection of oxidisable gases.

9. Application of the sensor according to claim 8 characterised in that the oxidisable gas is methane or carbon monoxide.

10. Application of the sensor according to any one of claims 1 to 7 to measuring the flowrate of fluids.

11. Sensor according to claim 1 characterised in that the interface area is a thin film deposited on at least one surface of the substrate near the hole.

12. Application of the sensor according to claim 11 to the detection and measurement of ionisable gases by ionisation chromatography.

13. Method of fabricating a filament type sensor for determining a static or dynamic characteristic of a surrounding environment, comprising a resistive element adapted to be heated in the environment by the JOULE effect and an interface area adapted to react with the environment in a physico-chemical process influencing an electrical characteristic of the interface area according to the characteristic to be determined, adapted to the manufacture of a sensor according to any one of claims 1 to 12, characterised in that it comprises the following stages:
- depositing onto the front and rear surfaces (1A, 1B) of a wafer-form substrate (1) a thin film front mask (12, 13, 15) incorporating a front window (17A) the shape of which reflects the shape of the filament (3) to be fabricated and has a central portion extended by end portions, and a thin film rear mask (11, 14) incorporating a rear window (16A) facing the central portion of the window excluding said ends but larger than this central portion,
- hollowing a trench (18) into the substrate by etching the front surface of the latter through the front mask,
- depositing onto the back of this trench one or more thin films (24A) adapted to constitute the filament, at least one of said thin films being an electrically conductive material, and
- eliminating the substrate to its full thickness by etching it through a mask (11, 25) the same shape as the rear mask.

14. Method of fabricating a filament type sensor for determining a static or dynamic characteristic of a surrounding environment, comprising a resistive element adapted to be heated in the environment by the JOULE effect and an interface area adapted to react with the environment in a physico-chemical process influencing an electrical characteristic of the interface area according to the characteristic to be determined, adapted to the manufacture of a sensor according to any one of claims 1 to 12, characterised in that it comprises the following stages:
- depositing onto the front and rear surfaces (1A, 1B) of a wafer-form substrate (1) a thin film front mask (12, 13) and an electrolytic deposit (13bis) incorporating a front window (17A) the shape of which reflects the shape of the filament (3) to be fabricated and has a central portion extended by end portions and a thin film rear mask (11, 11bis) incorporating a rear window (16A) facing the central portion of the window excluding said ends but larger than this central portion,
- hollowing a trench (18) into the substrate by etching the front surface of the latter through the front mask,
- depositing onto the back of this trench one or more thin films (24A) adapted to constitute the filament, at least one of said thin films being an electrically conductive material, and
- eliminating the substrate to its full thickness by etching it through a mask (11, 25) the same shape as the rear mask.

15. Method of fabricating a filament type sensor for determining a static or dynamic characteristic of a surrounding environment, comprising a resistive element adapted to be heated in the environment by the JOULE effect and an interface area adapted to react with the environment in a physico-chemical process influencing an electrical characteristic of the interface area according to the characteristic to be determined, adapted to the manufacture of a sensor according to any one of claims 1 to 12, characterised in that use is made of a metal-plated substrate incorporating a front window (17A) the shape of which reflects the shape of the filament (3) to be fabricated and has a central portion extended by end portions and a rear window (16A) facing the central portion of the window excluding said ends but larger than this central portion,
- a trench (18) is hollowed into the substrate by etching the front surface of the latter through the front mask,
- one or more thin films (24A) adapted to constitute the filament is deposited onto the back of this trench, at least one of said thin films being an electrically conductive material, and
- the substrate is eliminated to its full thickness by etching it through a mask (11, 25) the same shape as the rear mask.

16. Method according to any one of claims 13 to 15 characterised in that, before the substrate is etched through the rear mask to eliminate its entire thickness, a protective film (26) is deposited onto the front surface and into the trench and the protective film is removed after the substrate is etched.

17. Method according to claim 16 characterised in that the protective film on the front surface is a polymer resin.

18. Method according to any one of claims 13 to 17 characterised in that the front mask comprises an intermediate film (13) covered with a film (15) of resin, the thin film(s) of the filament being deposited, after removal of the resin film (15), by deposition of one or more thin films (24) into the trench (24A) and around the trench (24B) followed by removal of the thin film(s) (24B) deposited outside the trench by etching the intermediate film.

19. Method according to claim 18 characterised in that the substrate is of glass and the front mask comprises a gold film (13) covering a chromium film (12) deposited onto the front surface (1A) and at least one film of platinum is deposited onto the back of the front trench (18).

20. Method according to any one of claims 13 to 19 characterised in that at least one film of metal catalyst is deposited in the trench.

21. Method according to any one of claims 13 to 20 characterised in that at least three thin films (7, 8, 9) are deposited on the back of the trench, comprising a conductive material film, an insulative material film and a catalyst film.

22. Method according to any one of claims 13 to 21 characterised in that the substrate is chosen from the group of materials comprising glass, silicon, alumina, silica, quartz and polymers.
